(19) Europäisches Patentamt
European Patent Office
Office européen des brevets

(11) **EP 4 224 187 A1**

(12) **EUROPEAN PATENT APPLICATION**

(43) Date of publication:
**09.08.2023 Bulletin 2023/32**

(21) Application number: **22305123.6**

(22) Date of filing: **04.02.2022**

(51) International Patent Classification (IPC):
**G01R 33/26** (2006.01)     **G01R 33/32** (2006.01)
**G01N 24/00** (2006.01)

(52) Cooperative Patent Classification (CPC):
**G01R 33/26; G01N 24/006; G01R 33/323**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Wainvam-E**
**56270 Ploemeur (FR)**

(72) Inventors:
• **BEATO, François**
**56100 Lorient (FR)**
• **HINGANT, Thomas**
**35000 Rennes (FR)**

(74) Representative: **Novagraaf Technologies**
**Bâtiment O2**
**2, rue Sarah Bernhardt**
**CS90017**
**92665 Asnières-sur-Seine Cedex (FR)**

(54) **DEVICE AND METHOD FOR MEASURING A PHYSICAL PARAMETER**

(57)     A device and method for measuring a physical parameter are described. The device comprises a signal generator (68) for generating a signal representative of a fluorescence (67) emitted by nitrogen-vacancy centers of a diamond in response to excitation by a source of light (66). The device further comprises:
- a first microwave generator (61, 73) for generating a first microwave signal at a first frequency (f_MW,av, f'_MW,av) and a second microwave (62, 74) generator for generating a second microwave signal at a second frequency (f_MW,d, f'_MW,d), one of said first and second frequencies having been modulated at a third frequency (f_mod); wherein respective initial values of said first and second frequencies are such that the sum and the difference of said second and first frequencies are substantially equal to respective estimates of a first and a second resonance frequency of said nitrogen-vacancy centers;
- a signal processing circuit (53, 63) for combining said first and second microwave signals to obtain a third microwave signal comprising frequencies corresponding to the sum and the difference of said first and second frequencies and for providing said third microwave signal to a radiating component (64) configured to provide microwaves to said nitrogen-vacancy centers;
- a demodulator (69) for demodulating the signal representative of said fluorescence at said third frequency (f_mod);
- a processor (75) for determining said physical parameter measurement as a function of said demodulated signal.

**FIG. 6**

EP 4 224 187 A1

**Description**

TECHNICAL FIELD

A device and a method for measuring a physical parameter are disclosed. The device and method can be used in particular in the area of magnetic resonance detection and can be applied for example for measuring a magnetic field or a temperature.

BACKGROUND

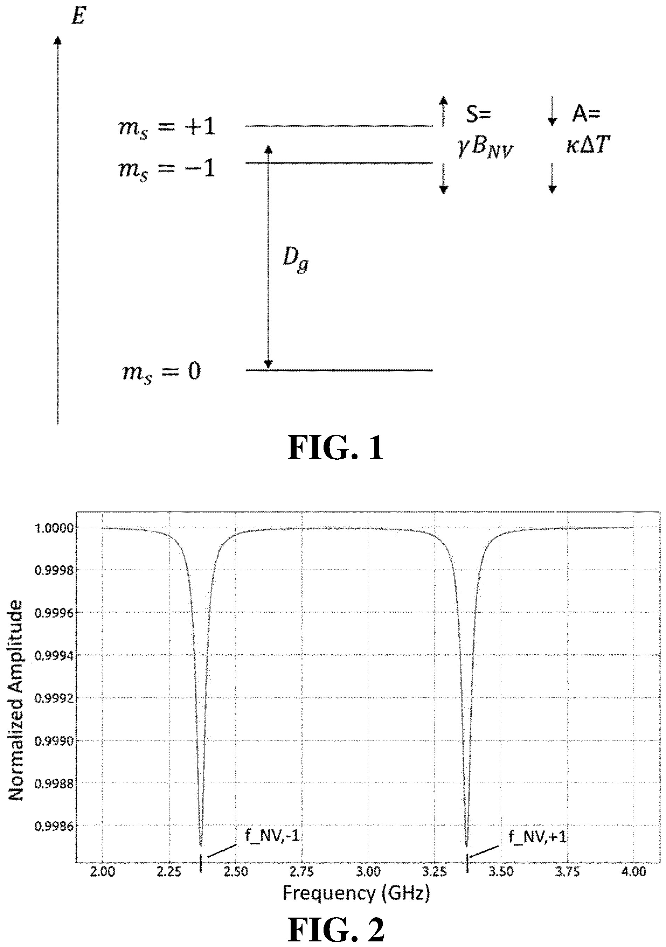

NV center doped diamonds are a promising candidate for measuring various physical parameters such as a magnetic field, a temperature, a strain or an electric field. NV center-based measurements rely on the use of the quantum properties of this defect, in particular the evolution of its energy levels. The fundamental state of NV centers is indeed a spin triplet state, comprised of three sublevels, characterized by their magnetic quantum number $m\_s=0, \pm 1$. Figure 1 illustrates the energy of these states. It must be noted that the Y axis can equivalently represent energy or frequency. Indeed, transitions between the spin levels $m\_s=0$ and $m\_s=\pm 1$ can occur when the system is excited by an oscillating magnetic field whose frequency matches the energy splitting divided by Planck's constant h. The impact of the transitions will be detailed below. The difference between the $m\_s=0$ and $m\_s=+1$ (resp. -1) states thus corresponds to a transition frequency $f_{NV,+1}$ (resp. $f_{NV,-1}$). In a theoretically perfect diamond, i.e. without any defects, the $m\_s=\pm 1$ states are degenerate (they have the exact same energy), while the $m\_s=0$ state is lower in energy. The nominal frequency difference between $m\_s=0$ and $m\_s=\pm 1$ is called the "zero-field splitting", $D\_g$. In addition, under particular conditions, the energies of the three levels change in a well-defined way, characteristic of these conditions. This will modify the frequencies $f_{NV,+1}$ and $f_{NV,-1}$ of the transitions accordingly. For instance, if a magnetic field is applied, the frequencies $f_{NV,+1}$ and $f_{NV,-1}$ move away from each other. The splitting between the two frequencies is in first approach proportional to the projection the magnetic field on the NV axis, $B\_NV$, with a proportionality factor $\gamma = 28.035(5)$ *GHz/T*. Conversely, if the temperature of the diamond changes, $f_{NV,+1}$ and $f_{NV,-1}$ move together in the same direction, with a proportionality factor $\kappa = -74kHz/K$. More generally, with respect to the nominal splitting frequency $D\_g$, the frequencies $f_{NV,+1}$ and $f_{NV,-1}$ can display a symmetric displacement S, or a common (or antisymmetric) displacement A:

$$f_{NV,\pm 1} = D_g + A \pm S \text{ (Eq. 1)}$$

The central frequency $(f_{NV,+1} + f_{NV,-1})/2$ is thus the sum of $D\_g$ and A.

This is schematically represented in FIG. 1, where the displacement due to the magnetic field, labelled $\gamma B_{NV}$, is of the symmetrical type 'S', whereas the displacement due e.g. to the temperature, labelled $\kappa\Delta T$, is of the asymmetrical type 'A'.

By measuring the resonance frequencies $f_{NV,\pm 1}$, a very precise measurement of the local parameters applied to the NV centers (magnetic field, temperature, ...) can be obtained. This is the basic principle of e.g. NV magnetometry.

In terms of measurement implementation, the process can be described as a three-step process:

- First, a green light (pumping light) is sent to the diamond and absorbed by the NV centers. The NV centers are thus brought out of thermal equilibrium and polarized in a specific quantum sublevel ($m\_s=0$) of the fundamental state. This state is highly fluorescent, and sometimes referred to as the bright state.
- Then a microwave field is applied to the NV centers. If the frequency f_MW of the field is resonant (i.e. equal to) one of the resonance frequencies $f_{NV,\pm 1}$ of the NV centers, then the NV centers are sent into another quantum sublevel ($m\_s=\pm 1$) of the fundamental state. These states are equivalently referred to as dark states because they emit less fluorescence compared to the bright state. Thus, tuning the microwave frequency f_MW to the resonance frequency $f_{NV,\pm 1}$ implies a decrease of the fluorescence intensity emitted by the NV centers.
- Finally, by observing this fluorescence level, one can measure exactly the frequency at which the resonance occurs, and by this means, infer the value of the magnetic field. This measurement scheme of the resonance through an optical detection is referred to as Optical Detection of the Magnetic Resonance (ODMR). By scanning the microwave frequency f_MW, a so-called ODMR spectrum can be obtained, as illustrated in FIG. 2, where $f_{NV,-1}$ and $f_{NV,+1}$ represent the two resonance frequencies.

However, as expressed before, several parameters may induce a change of the resonance frequencies, so that measuring only one resonance frequency can induce mistakes on the magnetic field measurement. This behavior is problematic since it renders the measurements unreliable. It is known to cancel the effect of some of the impacting parameters on the NV magnetic measurement by using the fact that the magnetic field induces a symmetric displacement (i.e. the resonance frequencies move into opposite directions) of the two resonance frequencies, while other parameters (in particular the temperature and isotropic strain) induce an asymmetric displacement (i.e. the resonance frequencies move into a same direction). Hence, monitoring in real time the motion of the two resonance frequencies allows computing their sum and difference to decorrelate asymmetric changes from symmetric ones:

$$\frac{\left(f_{NV,+1}+f_{NV,-1}\right)}{2} = D\_g + A \text{ (Eq. 2)}$$

$$\left|\frac{f_{NV,+1}-f_{NV,-1}}{2}\right| = S \text{ (Eq. 3)}$$

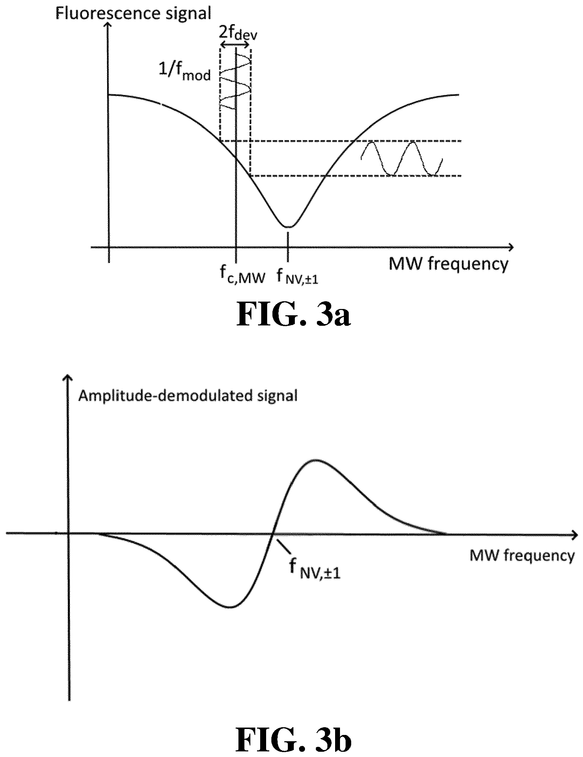

A way to track the position of one resonance frequency is to apply a frequency modulation to the microwave signal, as illustrated by FIG. 3a for a frequency range centered around one of the resonance frequencies f_NV,±1. In FIG. 3a, f_dev represents the modulation depth or frequency deviation, f_c,MW the center frequency of the modulating signal (chosen close to the resonance frequency) and f_mod the frequency of the modulating signal. After the optical detection, this frequency modulation on the microwave signal is apparent on the NV fluorescence signal as an amplitude modulation at f_mod. One can then demodulate the measured NV fluorescence signal at the modulation frequency f_mod to obtain what is called a dispersive curve, as illustrated by FIG. 3b. The process illustrated by FIG. 3a and FIG. 3b is described for example in [1]. The dispersive curve is centered on the resonance frequency f_NV,+1 (resp. f_NV,-1). Close to the resonance frequency, the dispersive curve is monotonous and it crosses zero at the resonance frequency. The dispersive curve thus allows obtaining a very accurate measurement of the resonance frequency, in real time. For this purpose, two possibilities may be considered:

- In open loop, the microwave central frequency f_c,MW is fixed close to the NV resonance frequency. A change in the NV resonance frequency f_NV directly translates the dispersive curve, which induces a change in the value of the demodulated fluorescence signal. The knowledge of both the central microwave frequency f_c,MW and the slope of the dispersive signal can be used to recover the position of the resonance f_NV.
- In closed loop, the microwave central frequency f_c,MW is adjusted dynamically, in order to cancel the value of the demodulated fluorescence signal. Because the dispersive curve crosses zero at the NV resonance frequency f_NV, the central frequency of the microwave signal directly gives the position of the resonance. This can be achieved by feedback to the microwave generator, for example through a PID controller.

In order to track the two resonance frequencies f_NV,±1 simultaneously, two microwave signals modulated in frequency are generated with central frequencies f_c,MW,±1 close to each of the NV resonances f_NV,±1. The two microwave signals are then combined to address the two NV resonances. In such a case, the modulations are designed not to interact with each other, so that none of the information contained in one modulation leaks into the other. This is achieved for example through the use of two incommensurable modulation frequencies f_mod,-1 and f_mod,+1 (e.g. 1111 Hz and 3257 Hz).

The two measured resonance values f_NV,±1 are then used to compute their sum and difference, to separate the magnetic field contribution from other effects such as temperature.

However, one needs to have all the modulation/demodulation/tracking systems functioning in parallel, so that both resonance frequencies can be tracked. This may be quite complicated and heavy to implement. Also, as mentioned, the modulation frequencies need to be separated to avoid cross talk between the two signals. For instance the two modulation frequencies (f_mod-1, f_mod+1) will generate harmonics (2.f_mod-1, 3.f_mod-1,..., 2.f_mod+1, 3.f_mod+1...) and potentially inter-harmonics as well (of the form |m.f_mod-1±n.f_mod+1|, with m,n being integers). The two modulation frequencies need to be chosen very carefully to avoid overlapping of two frequencies, and this will necessarily decrease the bandwidth of the system, since it is at most the interval between two adjacent harmonics frequencies.

Another possibility is to implement a time domain decorrelation between the modulations around f_c,MW,-1 and f_c,MW,+1, by alternating between the two. Although this will cancel the inter-harmonics, it still imposes a limitation on the bandwidth since at most half of the complete measurement time will be useful for the real measurement value.

It is therefore desirable to reduce at least certain of these drawbacks.

SUMMARY

The scope of protection is set out by the claims.

A first aspect concerns a device for measuring a physical parameter comprising:
a signal generator for generating a signal representative of a fluorescence emitted by nitrogen-vacancy centers of a diamond in response to excitation by a source of light; said device further comprising:

a first microwave generator for generating a first microwave signal at a first frequency and
a second microwave generator for generating a second microwave signal at a second frequency, one of said first and second frequencies having been modulated at a third frequency; wherein respective initial values of said first and second frequencies are such that the sum and the difference of said second and first frequencies are substantially equal to respective estimates of a first and a second resonance frequency of said nitrogen-vacancy centers,
a signal processing circuit for combining said first and second microwave signals to obtain a third microwave signal comprising frequencies corresponding to the sum and the difference of said first and second frequencies and for providing said third microwave signal to a radiating component configured to provide microwaves to said nitrogen-vacancy centers;
a demodulator for demodulating the signal representative of said fluorescence at said third frequency;

- a processor for determining said physical parameter measurement as a function of said demodulated signal.

According to a non-limiting exemplary embodiment, the device is configured to obtain said estimates by carrying out a frequency scan of a spectrum containing said resonance frequencies, applying a microwave signal at the scan frequency to said nitrogen-vacancy centers, exciting said nitrogen-vacancy centers using an excitation light and determining said estimates based on resonances of the fluorescence signal generated by said nitrogen-vacancy centers.

According to a non-limiting exemplary embodiment, the device comprises a feedback loop controller for controlling said one among said first and second frequencies that was modulated, wherein the demodulated signal output by said demodulator is fed as error signal to the feedback loop controller.

According to a non-limiting exemplary embodiment, the device comprises an adjustment module for receiving a signal from a sensor, said sensor sensing a physical parameter, wherein said adjustment module controls said first microwave generator to adjust said first frequency to compensate variations of said sensed physical parameter.

According to a non-limiting exemplary embodiment, said sensed physical parameter is temperature or pressure.

According to a non-limiting exemplary embodiment, said second microwave signal is frequency modulated and said measured physical parameter is a parameter which induces a symmetrical displacement of said resonance frequencies of said nitrogen-vacancy centers compared to a central frequency between said resonance frequencies.

According to a non-limiting exemplary embodiment, said measured physical parameter is a magnetic field within which the nitrogen-vacancy centers are placed.

According to a non-limiting exemplary embodiment, said first microwave signal is frequency modulated and said measured physical parameter is a parameter which induces an asymmetrical displacement of resonance frequencies compared to a central frequency.

According to a non-limiting exemplary embodiment, said signal processing circuit is a mixer receiving said first microwave signal on a local oscillator input port and said second microwave signal on an input signal port.

According to a non-limiting exemplary embodiment, a modulation depth of said frequency modulation is between 50 kHz and 10 MHz.

According to a non-limiting exemplary embodiment, said modulation frequency is between 0 Hz and 10 kHz.

A second aspect concerns a method for measuring a physical parameter carried out by a device comprising a processor and configured to obtain a signal representative of a fluorescence of nitrogen-vacancy centers in a diamond for sensing said physical parameter, the method comprising:

- obtaining initial values of first and second frequencies such that an estimate of a first resonance frequency and an estimate of a second resonance frequency of said nitrogen-vacancy centers are respectively substantially equal to the sum and the difference of the first and second frequencies;
- generating a first microwave signal at the first frequency and a second microwave signal at the second frequency, one of said first and second frequencies having been modulated at a third frequency;
- processing the first and second microwave signals to obtain a third microwave signal comprising frequencies corresponding to the sum and the difference of the first and second frequencies;
- obtaining said signal representative of said fluorescence produced by said nitrogen-vacancy centers exposed to a microwave field function of said third signal and an excitation light;
- demodulating said signal representative of the fluorescence at said modulation frequency;
- determining a value of said physical parameter as a function of said demodulated signal.

According to a non-limiting exemplary embodiment, the method further comprises, in the case where the second signal is modulated, correcting said second frequency using a feedback loop in which an error signal is function of said demodulated signal.

According to a non-limiting exemplary embodiment, the method further comprises, in the case where the first signal is modulated, correcting said first frequency using a feedback loop in which an error signal is function of said demodulated signal.

BRIEF DESCRIPTION OF THE DRAWINGS

Example embodiments will be more fully understood from the detailed description provided herein and the accompanying drawings, which are given by way of illustration only. In the present description and in the drawings, the notations X_y and Xy are equivalent.

FIG. 1 is a schematic representation of the energy levels of the fundamental state of an NV center;
FIG. 2 is a schematic diagram of a simulated curve of an optical detection of magnetic resonance ('ODMR');
FIG. 3a is an exemplary ODMR signal to which frequency modulation of a microwave signal is applied;
FIG. 3b is a dispersive curve resulting from the demodulation of the signal obtained from the process illustrated by FIG. 3a;
FIG. 4 is a diagram illustrating the choice of alternate frequencies according to a non-limiting exemplary embodiment;
FIG. 5 is a block diagram of functional components for obtaining resonance frequencies as a function of the alternate frequencies;
FIG. 6 is a block diagram of a first device for measuring a physical parameter according to a non-limiting exemplary embodiment;
FIG. 7 is a functional block diagram of a second device for measuring a physical parameter according to a non-limiting exemplary embodiment;
FIG. 8 is a functional block diagram of a subsystem for providing a feedback loop to be considered for embodiments such as those of FIG. 6 and FIG. 7;
FIG. 9 is a flowchart of a method according to a non-limiting exemplary embodiment, which may be implemented by the device of FIG. 6;
FIG. 10 is a flowchart of a method according to another non-limiting exemplary embodiment, which may be implemented by the device of FIG. 7.

It should be noted that these figures are intended to illustrate the general characteristics of methods, structure and/or materials utilized in the described exemplary embodiments. The drawings are not to scale and should not be interpreted as limiting the range of values or properties encompassed by the exemplary embodiments.

DETAILED DESCRIPTION

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

It should be appreciated by those skilled in the art that any functions, engines, block diagrams, flow diagrams, state transition diagrams and / or flowcharts herein represent conceptual views of illustrative circuitry embodying the principles of the exemplary embodiments. Functions, actions or steps described herein can be implemented in hardware or software or any combination thereof. If implemented in software, the functions, blocks of the block diagrams and/or flowchart illustrations can be implemented e.g. using software code executed by a processor or a processing device.

In the present description, functional blocks denoted as "means configured to perform ..." a certain function are to be understood as functional blocks comprising circuitry that is adapted for performing or configured to perform a certain function. Moreover, any entity described herein as "means", may be implemented as one or more distinct entities or within an entity providing additional functions. When provided by a processor, the functions may be provided by a single processor or several processors. Moreover, the term "processor" includes one or more of a digital signal processor, remote processor, graphical processing units ('GPUs'), dedicated or generic circuitry, read only memory for storing software, random access memory, and non-volatile storage.

According to the present disclosure, instead of combining directly two microwave signals modulated with a central frequency $f_{c,MW\pm1}$ close to the resonance frequencies of the NV centers $f_{NV,\pm1}$, two microwave signals are generated in a first step, with frequencies $f_{MW,av}$ and $f_{MW,d}$. The frequencies $f_{MW,av}$ and $f_{MW,d}$ are not the resonance frequencies of the NV center. With the signals at $f_{MW,av}$ and $f_{MW,d}$, a third microwave signal is generated in a second step, which contains frequencies close to the NV resonances.

According to one embodiment, the microwave signal containing frequencies close to the resonance frequencies of the NV is obtained by implementing a circuit that processes the signals at the two frequencies f_MW,av and f_MW,d, so that the resulting microwave signal contains frequencies corresponding to the sum and difference of the two frequencies f_MW,av and f_MW,d.

In order to address the NV resonances, the frequencies f_MW,av and f_MW,d are chosen based on an estimate of the NV resonance frequencies f_NV,±1.

According to one embodiment, the NV resonance frequencies are estimated in an initialization step, by recording an ODMR spectrum like the one of FIG. 2. For this purpose, the frequency of the microwave signal f_MW applied to the NV centers is varied to scan through a spectrum containing the NV center resonance frequencies f_NV,±1, while recording the fluorescence of the NV centers. The spectrum to be scanned can be selected as a function of the maximum expected magnetic field. This allows obtaining the desired estimates fest_NV,±1. f_MW,av is then chosen to match the central frequency, $f_{MW,av} = \frac{1}{2}\left(fest_{NV,-1} + fest_{NV,+1}\right)$, and f_MW,d is chosen to match the splitting S, $f_{MW,d} = S = \frac{1}{2}\left|fest_{NV,-1} - fest_{NV,+1}\right|$. Because f_NV,±1 correspond to transition frequencies, they are positive and hence f_MW,av ≥ f_MW,d.

The NV resonance frequencies may be estimated using other methods. According to a variant embodiment, an approximate value of the magnetic field and the temperature are obtained using appropriate sensors, and these approximate values are then used to calculate the estimated positions of the NV resonance frequencies.

Because of the choice of f_MW,av and f_MW,d, their sum and difference corresponds to the first estimates of the NV resonance frequencies f_NV,±1.

By combining the two signals at frequencies $f_{MW,av}$ and $f_{MW,d}$, for example using a hardware circuit such as a mixer, one obtains a microwave signal containing frequencies close to f_NV,-1 and f_NV,+1. This signal is conveyed through appropriate means to the NV diamond (or an NV diamond array), e.g. using a cable and a resonator placed in proximity of the NV diamond (or NV diamond array), so that the diamonds are excited at these frequencies. However, the sum and difference of f_MW,av and f_MW,d can also be obtained through other means than a mixer.

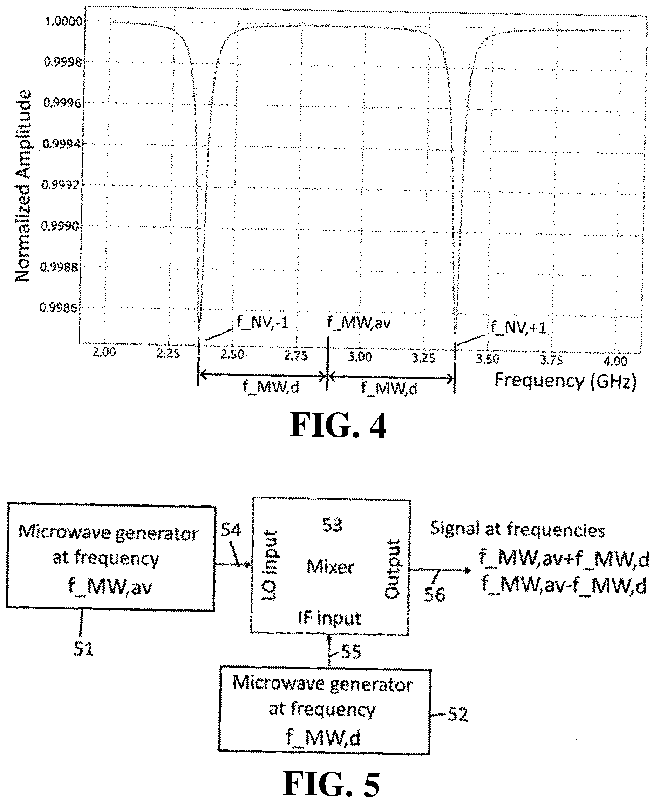

FIG. 5 illustrates a mixer that may be used to combine the two alternate frequency signals at f_MW,av and f_MW,d. Mixer 53 comprises a local oscillator ('LO') port 54 connected to a first microwave signal generator 51 at frequency $f_{MW}$,av, an input signal (input frequency 'IF') port 55 connected to a second microwave signal generator 52 at frequency $f_{MW,d}$ and an output port 56 for providing a signal at frequencies $f_{MW}$,av + $f_{MW,d}$ and $f_{MW,av}$ - $f_{MW,d}$. As will be seen later, according to the various embodiments and variants described herein, either of the signals at $f_{MW,av}$ or at $f_{MW,d}$ will be frequency modulated prior to being provided to the mixer.

Advantageously, a frequency modulation is added to either $f_{MW,av}$ or $f_{MW,d}$, the instantaneous frequencies having the form of $f'_{MW,av} = f_{c,MW,av,} + f_{dev}g(f_{mod})$ or $f'_{MW,d} = f_{c,MW,d} + f_{dev}g(f_{mod})$, where $g$ is a periodic function, of frequency $f_{mod}$, and where $f_{dev}$ is the frequency deviation. At the output of the mixer 53, the modulation $f_{dev}g(f_{mod})$ is therefore replicated on the two instantaneous frequencies f'_MW,av + f_MW,d and f'_MW,av - f_MW,d (respectively f_MW,av + f_MW,d and f_MW,av - f'_MW,d). Since f_MW,av and f_MW,d are chosen so that their sum and difference are function of both of the NV resonances, each resonance of the NV center is addressed simultaneously by the same frequency modulation $\pm f_{dev}g(f_{mod})$.

The sign depends on whether the modulation is performed on f_MW,av or f_MW,d. If the modulation is on f_MW,av, both f'_MW,av + f_MW,d and f'_MW,av - f_MW,d are modulated in phase, while if the modulation is on f_MW,d, both f_MW,av + f_MW,d and f_MW,av - f'_MW,d are modulated in opposition of phase. After amplitude demodulation at f_mod of the fluorescence signal of the NV center, the contribution of both resonances is either added or subtracted, depending on whether the modulations around both resonances f_NV,±1 are in phase or in opposition of phase.

In the presence of a magnetic field (or any external excitation which splits the resonance frequencies f_NV,±1 symmetrically), both resonance frequencies will move away from each other. Such splitting of the NV resonances on the demodulated fluorescence signal can only be observed if the modulations addressing the NV are in opposition of phase. Conversely, if an excitation shifts both NV resonances in the same direction (e.g. temperature or isotropic strain), the demodulated fluorescence of the NV will change only if the modulations around the NV frequencies are in phase. If they are in opposition of phase, the same shift of the resonances will not modify the demodulated signal.

Under the assumption of a small modulation depth with respect to the width of the resonance (typically smaller than one tenth of the resonance width), the following approximated equations can be used:

$$S_{tot} = S_{res,1}\left(f_{MW,av} - f_{MW,d}\right) + S_{res,2}\left(f_{MW,av} + f_{MW,d}\right) \text{ (Eq. 4)}$$

where S_res,1 and S_res,2 are functions which describe the fluorescence signal centered on the resonance frequencies f_NV,±1 of the NV center.

With a modulation on $f_{MW,av}$, equation 4 can be expressed as follows:

$$S_{tot} = S_{res,1}\left(\left(f_{MW,av} + f_{dev}\, g(f_{mod})\right) - f_{MW,d}\right) + S_{res,2}\left(\left(f_{MW,av} + f_{dev}\, g(f_{mod})\right) + f_{MW,d}\right)$$

$$\text{(Eq. 5)}$$

$$S_{tot} \approx S_{res1}\left(f_{MW,av} - f_{MW,d}\right) + S_{res2}\left(f_{MW,av} + f_{MW,d}\right) +$$

$$\frac{\mathrm{d}S_{res1}\left(f_{MW,av} - f_{MW,d}\right)}{\mathrm{d}\left(f_{MW,av} - f_{MW,d}\right)} f_{dev}\, g(f_{mod}) + \frac{\mathrm{d}S_{res2}\left(f_{MW,av} + f_{MW,d}\right)}{\mathrm{d}\left(f_{MW,av} + f_{MW,d}\right)} f_{dev}\, g(f_{mod}) \quad \text{(Eq. 6)}$$

With a modulation on $f_{MW,d}$, equation 4 can be expressed as follows:

$$S_{tot} = S_{res1}\left(f_{MW,av} - \left(f_{MW,d} + f_{dev}\, g(f_{mod})\right)\right)$$

$$+ S_{res2}\left(f_{MW,av} + \left(f_{MW,d} + f_{dev}\, g(f_{mod})\right)\right)$$

$$\text{(Eq. 7)}$$

$$S_{tot} \approx S_{res1}\left(f_{MW,av} - f_{MW,d}\right) + S_{res2}\left(f_{MW,av} + f_{MW,d}\right) -$$

$$\frac{\mathrm{d}S_{res1}\left(f_{MW,av} - f_{MW,d}\right)}{\mathrm{d}\left(f_{MW,av} - f_{MW,d}\right)} f_{dev}\, g(f_{mod}) + \frac{\mathrm{d}S_{res2}\left(f_{MW,av} + f_{MW,d}\right)}{\mathrm{d}\left(f_{MW,av} + f_{MW,d}\right)} f_{dev}\, g(f_{mod}) \quad \text{(Eq. 8)}$$

After the amplitude demodulation at f_mod, only the derivative terms remain, each of which corresponds to dispersive curves like the one of FIG.3b. Close to the center of the dispersive curves, their expression can be linearized as follows:

$$\frac{\mathrm{d}S_{res1}\left(f_{MW,av} - f_{MW,d}\right)}{\mathrm{d}\left(f_{MW,av} - f_{MW,d}\right)} \approx \alpha \cdot \left(f_{MW,av} - f_{MW,d} - f_{NV-1}\right) \quad \text{(Eq. 9)}$$

$$\frac{\mathrm{d}S_{res2}\left(f_{MW,av} + f_{MW,d}\right)}{\mathrm{d}\left(f_{MW,av} + f_{MW,d}\right)} \approx \alpha \cdot \left(f_{MW,av} + f_{MW,d} - f_{NV+1}\right) \quad \text{(Eq. 10)}$$

where $\alpha$ represents the slope of the dispersive curve close to its intersection with 0. In continuous operation, it is to be noted that this curve is not obtained in its entirety since according to the present embodiment (with the possible exception for deriving the initial estimates of the NV center resonance frequencies), no complete spectrum scan is performed that would for example allow to generate the graph of FIG. 2 - only two specific frequencies - possibly modulated as described - are generated.

The complete demodulated signal can be expressed as follows:

With a modulation on $f_{MW,av}$:

$$S_{demod} \approx \alpha.\left(f_{MW,av} - f_{MW,d} - f_{NV,-1}\right) + \alpha.\left(f_{MW,av} + f_{MW,d} - f_{NV,+1}\right) \text{ (Eq. 11)}$$

$$S_{demod} \approx 2\alpha.\left(f_{MW,av} - \left(f_{NV-1} + f_{NV,+1}\right)\right) \approx 2\alpha.\left(f_{MW,av} - \left(D_g + A\right)\right) \text{ (Eq. 12)}$$

With a modulation on $f_{MW,d}$:

$$S_{demod} \approx -\alpha.\left(f_{MW,av} - f_{MW,d} - f_{NV,-1}\right) + \alpha.\left(f_{MW,av} + f_{MW,d} - f_{NV,+1}\right) \text{ (Eq. 13)}$$

$$S_{demod} \approx 2\alpha.\left(f_{MW,d} - \left(f_{NV+1} - f_{NV,-1}\right)\right) \approx 2\alpha.\left(f_{MW,d} - S\right) \text{ (Eq. 14)}$$

Describing small modulation depths, as defined herein, is useful to derive simple and intuitive equations. In practice, however, there is no limitation to modulation depths small with respect to the width of the resonance. In any case, a dispersive curve can be derived, which crosses 0 monotonously. The crossing with 0 can therefore be used in any case to locate the central frequency of the dispersive curve.

According to the principles described above, it is possible by selectively frequency modulating either $f_{MW,av}$ or $f_{MW,d}$ to determine directly either $f_{NV,+1}$ - $f_{NV,-1}$ or $f_{NV,+1}$ + $f_{NV,-1}$, and thus to eliminate the influence of other physical parameters than the physical parameter to be measured. For example, by modulating f_MW,d, only the term $f_{NV,+1}$ - $f_{NV,-1}$ = 2S = $2\gamma B_{NV}$ is measured, without influence of the temperature. Similarly, by modulating f_MW,av, only the term $f_{NV,+1}$ + $f_{NV,-1}$ = 2A + $2D_g$ is measured, without the influence of the magnetic field, and where for a temperature variation, $A = \kappa \Delta T$. There is no issue of harmonics crosstalk of two modulation frequencies, since only one such modulation frequency is used. Moreover, the maximum available bandwidth can be used since there is no need for a separation of the two resonance frequency measurements, whether in the time or the frequency domain.

According to variant embodiments, closed-loop control is implemented on the central frequency of the modulation f_c,MW,av(resp. f_c,MW,d), in order to track the evolutions of A (resp. S). The notation f_c,MW,av and f_c,MW,d designate respectively the frequencies f_MW,av and f_MW,d when a modulation term is to be added - however, the notations with and without 'c' can be used interchangeably.

Depending on the desired application (i.e. with regard to the physical parameter to be measured), a measuring device will either implement the process applying the frequency modulation on $f_{MW,av}$ or on $f_{MW,d}$ . In a magnetometry configuration, the frequency modulation is applied on $f_{MW,d}$ to eliminate the influence of temperature, and isotropic strain. A device to measure either temperature or the isotropic strain (pressure) would apply a frequency modulation to $f_{MW,av}$ - one of the physical parameters can then be obtained e.g. in an environment in which the other parameters are known, for example in a controlled environment. According to a variant embodiment, a same device possesses modulator circuitry that selectively modulates either $f_{MW,av}$ or $f_{MW,d}$ as needed with regard to the type of measurement to be made.

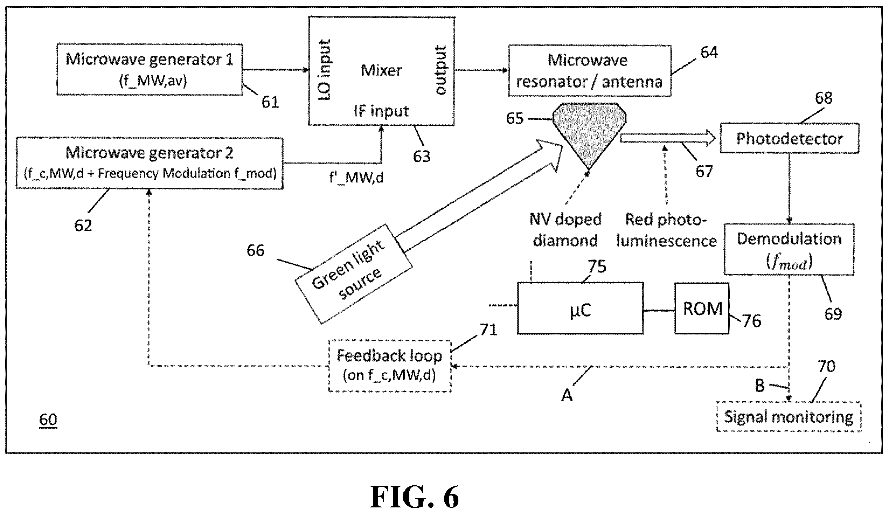

FIG. 6 is a functional block diagram of a measurement device 60 according to a non-limiting exemplary embodiment in which the physical parameter to be measured induces a symmetric displacement of the resonance frequencies. This is the case for a longitudinal magnetic field, i.e. aligned with the NV preferred axis (the physical axis created by the alignment of the nitrogen atom and the vacancy site). Considering the notation used earlier (in particular equations 1 to 4 and 15), S = $\gamma B_{NV}$, where $\gamma$ = 28.035(5) *GHz/T* is the gyromagnetic ratio of the NV center for a longitudinal magnetic field.

The device 60 comprises a first microwave generator 61 for generating a microwave signal at frequency $f_{MW,av}$ as well as a second microwave generator 62 for generating a microwave signal at frequency $f_{MW,d}$. A frequency of the form $f_{dev}$ $g(f_{mod})$ is added to $f_{MW,d}$ for providing a frequency modulated signal, where $f_{mod}$ is the modulation frequency, $f_{dev}$ is the modulation depth and g is a periodic function. According to a non-limiting embodiment, $f_{mod}$ is chosen low enough to lie within the NV bandwidth (for example between 200 Hz and 1kHz, or even between 0 Hz and 10 kHz). $f_{dev}$ is chosen to be of the order of the resonance line width - typically between 50 kHz 10 MHz..

The output of both generators is provided to mixer 63, with the local oscillator input of mixer 63 being fed with the signal at frequency $f_{MW,av}$ and the intermediate frequency input of mixer 63 being fed with the signal at frequency $f_{MW,d}' = f_{MW,d} + f_{dev}$ $g(f_{mod})$. The output of the mixer, containing frequencies at $f_{MW,av} + f'_{MW,d}$ and $f_{MW,av} - f'_{MW,d}$, is provided to a microwave emitter 64 (typically a resonator or antenna), which is placed in proximity of an NV doped diamond (or diamond array) 65 so as to emit microwaves on the NV centers of the diamond. A green light source 66, e.g. a laser, of a suitable wavelength to place the NV centers into the fundamental m_s=0 state, e.g. between 500 and 600 nm, illuminates the diamond. The green light may be conveyed to the diamond using e.g. an optical fiber. According to the embodiment illustrated by FIG. 6, the measurement of the red photoluminescence is performed using ODMR. A photodetector 68 collects the red photoluminescence 67 generated by the NV centers. The resulting signal is provided to a demodulator 69, which demodulates the signal at the frequency $f_{mod}$ to recover the dispersive signal, sensitive only to the magnetic field but insensitive to temperature. Paths A and B respectively show a closed loop implementation and an open loop implementation.

The dispersive signal can be used in open loop (as shown by path B) to infer the physical parameter to be measured inducing a symmetric displacement, in this case the amplitude of the magnetic field, by determining the splitting $2S = f_{NV+1} - f_{NV,-1}$ between the resonance frequencies of the NV center:

$$S_{measured} = f_{c,MW,d} - \frac{S_{demod}}{2\alpha} \text{ (Eq. 15)}$$

$\alpha$ corresponds to the slope of the dispersive signal close to the crossing with 0. Its value can be obtained by prior calibration, for example by scanning the central frequency of the modulated microwave $f_{c,MW,d}$ under a constant magnetic field, or by varying the magnetic field in a calibrated way under a fixed microwave excitation. The longitudinal magnetic field (along the NV axis) is obtained by $B_{NV} = \frac{S_{measure}}{\gamma}$ .

In alternative path A, the sensor is operated in closed loop. The demodulated signal is fed into a feedback loop controller 71. The controller is for example implemented as a proportional integral derivative (PID) controller. In this case the demodulated fluorescence signal $S_{demod}$ can be directly used as the error signal, i.e. the input of the feedback loop. The feedback loop therefore ensures that the measured demodulated signal is always cancelled, i.e. $S_{demod} = 0$. Because of this, the central frequency f_c,MW,d is directly equal to the symmetric resonance frequency splitting parameter $S_{measure}$ = $f_{c,MW,d}$. The PID parameters are set in coherence with the system characteristics in a known fashion per se to ensure a good stability. The output of the PID is connected to the adequate microwave generator to correct its central frequency.

$$B_{NV} = \frac{S_{measure}}{\gamma}$$

The value of the magnetic field is obtained, like in closed loop, by applying                                         .

Device 60 also comprises a processor 75 and a memory 76. Memory 76 contains software code that when executed by the processor 75, causes the processor to cause the device 60 to perform the steps of the methods described herein and to control the different functional blocks and/or components of the device for that purpose. The processor 75 in particular carries out the calculations required to obtain the value of the physical parameter. Element 70 in FIG. 6 is a display, which may or may not be part of the device 60, for displaying the measurement value obtained, whatever the path. For this purpose, processor 75 causes the device 60 to generate a signal representative of the measurement value.

According to variant embodiments, certain components shown as part of device 60 in FIG. 6 are external to the device and be connected to it through appropriate connections. For example, the microwave resonator 64 and the diamond 65 can be part of a sensor head detachably connected to the source of the microwave signal for exciting the diamond (such as mixer 63) through an appropriate cable and to the green light source 66 and the photodetector 68 through an optical fiber for both excitation and collection or distinct optical fibers for respectively excitation and collection.

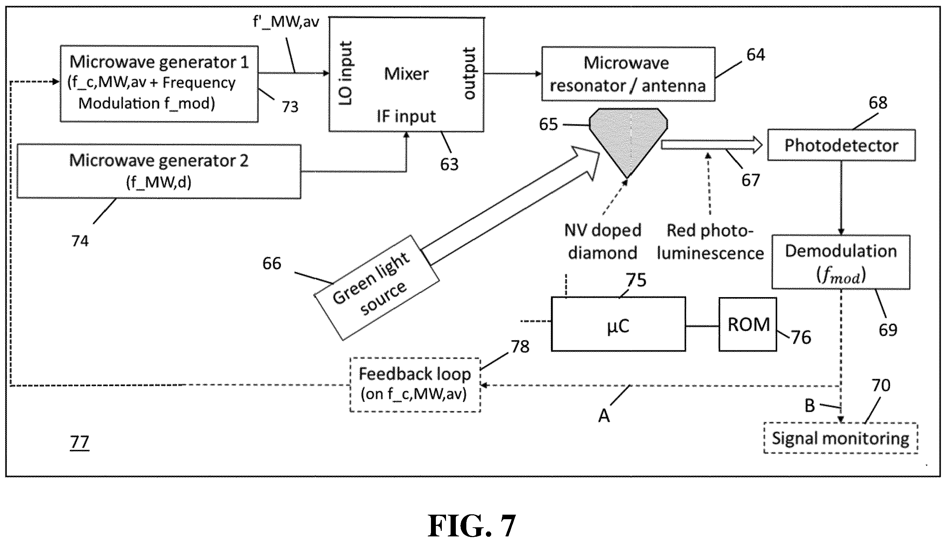

FIG. 7 is a block diagram of a device 77 according to another embodiment, according to which a frequency modulation is added to $f_{MW,av}$ instead of $f_{MW,d}$. Device 77 of FIG. 7 differs from device 60 of FIG. 6 by microwave generator 1, referenced 73, providing a modulated signal $f_{MW,av}' = f_{c,MW,av} + f_{dev} g(f_{mod})$, microwave generator 2, referenced 74, providing a signal $f_{c,MW,d}$ without additional modulation, and feedback loop controller 78, which controls the central frequency of the first microwave generator.

The dispersive signal can be used (as shown by path B) to determine the physical parameter to be measured inducing an asymmetric displacement, in this case the temperature drift, by applying:

$$A_{measure} = \kappa\Delta T = f_{c,MW,av} - D_g - \frac{S_{demod}}{2\alpha} \qquad \text{(Eq. 16)}$$

As with FIG. 6, the device of FIG. 7 also provides a feedback loop path A. It is to be noted that a device may implement either path A or path B, or both paths A and B with switching between the two paths being performed as desired or needed.

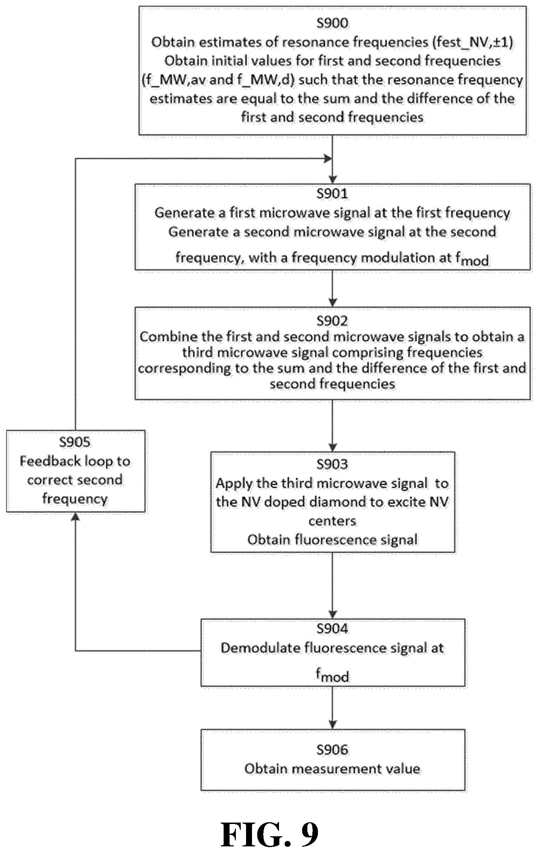

FIG. 6 and FIG. 7 show functional blocks, the functions of which may be combined or split differently according

**EP 4 224 187 A1**

to a specific implementation. For example, while according to the exemplary embodiments shown in FIG. 6 and 9, the frequency modulation is added by the microwave generators, it may very well be added by a separate component.

According to a variant embodiment, a measurement device, otherwise similar to the devices shown in FIG. 6 and FIG. 7, comprises a frequency modulation component that can be switched to modulate either $f_{MW,av}$ or $f_{MW,d}$ as required. The switching can be controlled by processor 75, for example to measure different parameters in a time-multiplexed fashion.

It is to be noted that the detection of the red fluorescence may be performed through other means than ODMR, for example using Photoelectric Detection of Magnetic Resonance (PDMR), e.g. through electrodes placed on the diamond.

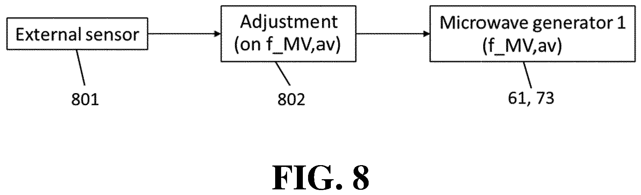

According to a variant embodiment, the measurement device comprises a dynamic adjustment on $f_{MW,av}$. FIG. 8 is a functional block diagram of a subsystem comprising a sensor 801 which may be part of the measurement device or external, in order to compensate for changes of the associated parameters. This ensures that the system does not go out of resonance, and may greatly improve the dynamic range of the system. An adjustment - or tracking - module 802 receives the sensor signal as input, and outputs controls to the frequency $f_{MW,av}$ microwave generator 61 or 73 to stay at the center of the system resonance. For example, the sensor 801 is a thermometer. The adjustment module 802 may be a distinct circuit, part of a circuit performing additional functions or be implemented at least partially using processor 75 receiving the sensor input and controlling the microwave generator.

FIG. 9 is a flowchart of a method according to a non-limiting embodiment in which a frequency modulation at f_mod is added to $f_{MW,d}$.

At S900, estimates of the resonance frequencies ($fest_{NV,+1}$ and $fest_{NV,-1}$) are obtained. Initial values for first and second frequencies ($f_{MW,av}$ and $f_{MW,d}$). are obtained, such that the estimate of the first resonance frequency is equal to the sum of the first and second frequencies, and the estimate of the second resonance frequency is equal to the difference between the first and second frequencies. This can also be written as follows, when seen from the first and second frequencies:

$$f_{MW,av} = \frac{1}{2}(fest_{NV,-1} + fest_{NV,+1}) \qquad f_{MW,d} = \frac{1}{2}(fest_{NV,+1} - fest_{NV,-1})$$

Microwave signals are then generated (S901), at the first frequency and at the second frequency $f_{MW,d}$ additionally modulated with a function at a frequency f_mod , the sum of $f_{MW,d}$ and the modulation at f_mod being labelled $f'_{MW,d}$ for convenience. The microwave signals at the first frequency $f_{MW,av}$ and the frequency modulated second frequency $f'_{MW,d}$ are processed (S902) to obtain a third microwave signal at frequencies corresponding to the sum and the difference of $f_{MW,av}$ and $f'_{MW,d}$. This is typically achieved using a mixer, as mentioned earlier. The third microwave signal is used to apply a microwave field to the NV doped diamond, the NV centers being excited using an appropriate light source, and the resulting fluorescence is collected to obtain a signal representative of the fluorescence (S903). The fluorescence signal is amplitude demodulated (S904) at the frequency f_mod. The demodulated signal can be used as an error signal of a feedback loop to control $f_{MW,d}$ (S905) or be used to obtain a value of the parameter that is to be determined (S906), as previously explained.

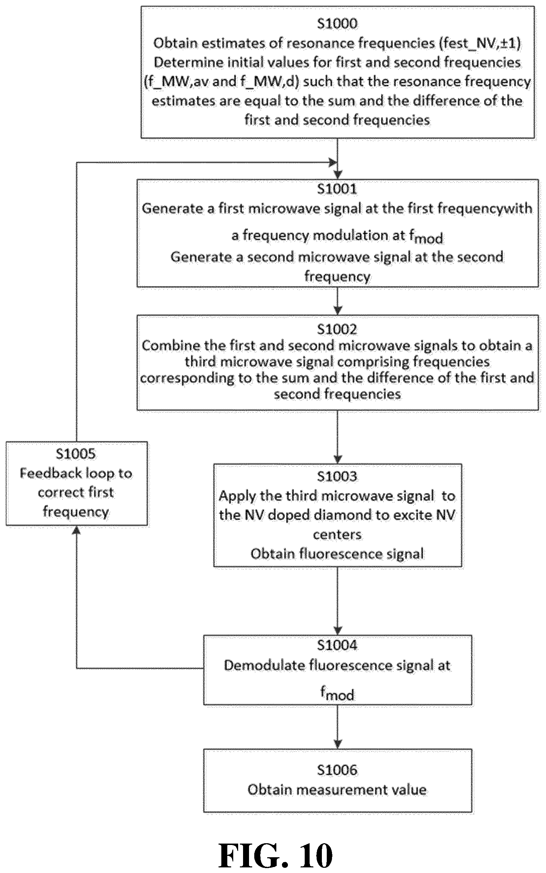

FIG. 10 is a flowchart of a method according to a non-limiting embodiment in which a frequency modulation at f_mod is added to $f_{MW,av}$.

At S1000, estimates of the resonance frequencies ($fest_{NV,+1}$ and $fest_{NV,-1}$) are obtained. Initial values for first and second frequencies ($f_{MW,av}$ and $f_{MW,d}$). are obtained, such that the estimate of the first resonance frequency is equal to the sum of the first and second frequencies, and the estimate of the second resonance frequency is equal to the difference between the first and second frequencies. This can also be written as follows, when seen from the first and second frequencies:

$$f_{MW,av} = \frac{1}{2}(fest_{NV,-1} + fest_{NV,+1}),$$
$$f_{MW,d} = \frac{1}{2}(fest_{NV,+1} - fest_{NV,-1})$$

Microwave signals are then generated (S1001) at the first frequency (additionally modulated with a function at a frequency f_mod the sum of $f_{MW,av}$ and the modulation at f_mod being labelled $f'_{MW,av}$ for convenience) and at the second frequency $f_{MW,d}$. The microwave signals at the frequency modulated first frequency $f'_{MW,av}$ and the second frequency $f_{MW,d}$ are processed (S1002) to obtain a third microwave signal at frequencies corresponding to the sum and the difference of $f'_{MW,av}$ and $f_{MW,d}$. This is typically achieved using a mixer, as mentioned earlier. The third microwave signal is used to apply a microwave field to the NV doped diamond, the NV centers being excited using an appropriate light source, and the resulting fluorescence is collected to obtain a signal representative of the fluorescence (S1003). The fluorescence signal is amplitude demodulated (S1004) at the frequency f_mod. The demodulated signal can be used as an error signal of a feedback loop to control $f_{MW,av}$ (S1005) or be used to obtain a value of the parameter that

10

is to be determined (S1006), as previously explained.

According to an additional embodiment, frequency modulations are added to both $f_{MW,av}$ and $f_{MW,d}$, based on distinct modulation frequencies f_mod1 and f_mod2. While this may add circuitry for modulating both signals and not provide the advantage of avoiding inter-harmonics due to these modulation frequencies, obtaining measurement values for distinct parameters such as magnetic field and temperature can be performed in parallel. Moreover, there is no need to use software processing of the signals to remove the impact of parameters inducing an asymmetric translation (A) of the resonance frequencies on the measurement of the parameters inducing a symmetric motion (S) of the resonance frequencies, or vice-versa - as before, the use of a simple hardware mixer is sufficient for this purpose. The signals obtained through this method are directly associated with the parameters of interest. This can be implemented either in an open loop configuration, where the measurements are deduced as discussed above, or using a closed loop scheme, where the two demodulated signals are used as error signals to feed respective feedback loops, and where the output of these feedback loops are used to control the two frequencies $f_{MW,av}$ and $f_{MW,d}$

Reference documents

[1] A. Grosz, M. J. Haji-Sheikh, and S. C. Mukhopadhyay, editors, High Sensitivity Magnetometers (Springer International Publishing, 2017), pages 553-576.

**Claims**

1. A device for measuring a physical parameter comprising a signal generator (68) for generating a signal representative of a fluorescence (67) emitted by nitrogen-vacancy centers of a diamond in response to excitation by a source of light (66); said device further comprising:

   - a first microwave generator (61, 73) for generating a first microwave signal at a first frequency (f_MW,av, f'_MW,av) and a second microwave (62, 74) generator for generating a second microwave signal at a second frequency (f_MW,d, f'_MW,d), one of said first and second frequencies having been modulated at a third frequency (f_mod); wherein respective initial values of said first and second frequencies are such that the sum and the difference of said second and first frequencies are substantially equal to respective estimates of a first and a second resonance frequency of said nitrogen-vacancy centers;
   - a signal processing circuit (53, 63) for combining said first and second microwave signals to obtain a third microwave signal comprising frequencies corresponding to the sum and the difference of said first and second frequencies and for providing said third microwave signal to a radiating component (64) configured to provide microwaves to said nitrogen-vacancy centers;
   - a demodulator (69) for demodulating the signal representative of said fluorescence at said third frequency (f_mod);
   - a processor (75) for determining said physical parameter measurement as a function of said demodulated signal.

2. Device according to claim 1, wherein said device is configured to obtain said estimates by carrying out a frequency scan of a spectrum containing said resonance frequencies, applying a microwave signal at the scan frequency to said nitrogen-vacancy centers, exciting said nitrogen-vacancy centers using an excitation light and determining said estimates based on resonances of the fluorescence signal generated by said nitrogen-vacancy centers.

3. Device according to claim 1 or 2, further comprising a feedback loop controller (71, 77) for controlling said one among said first and second frequencies that was modulated, wherein the demodulated signal output by said demodulator (69) is fed as error signal to the feedback loop controller.

4. Device according to one of the claims 1 to 3, further comprising an adjustment module (802) for receiving a signal from a sensor (801), said sensor sensing a physical parameter, wherein said adjustment module controls said first microwave generator to adjust said first frequency (f_MW,av) to compensate variations of said sensed physical parameter.

5. Device according to claim 4, wherein said sensed physical parameter is temperature or pressure.

6. Device according to one of the claims 1 to 3, wherein said second microwave signal is frequency modulated and said measured physical parameter is a parameter which induces a symmetrical displacement (S) of said resonance frequencies of said nitrogen-vacancy centers compared to a central frequency between said resonance frequencies.

7. Device according to claim 6, wherein said measured physical parameter is a magnetic field within which the nitrogen-vacancy centers are placed.

8. Device according to one of the claims 1 to 5, wherein said first microwave signal is frequency modulated and said measured physical parameter is a parameter which induces an asymmetrical displacement (A) of resonance frequencies compared to a central frequency.

9. Device according to one of the claims 1 to 8, wherein said signal processing circuit is a mixer (53) receiving said first microwave signal on a local oscillator input port (54) and said second microwave signal on an input signal port (55).

10. Device according to one of the claims 1 to 9, wherein a modulation depth of said frequency modulation is between 50 kHz and 10 MHz..

11. Device according to one of the claims 1 to 10, wherein said modulation frequency is between 0 Hz and 10 kHz.

12. Method for measuring a physical parameter carried out by a device (60) comprising a processor (75) and configured to obtain a signal representative of a fluorescence of nitrogen-vacancy centers in a diamond for sensing said physical parameter, the method comprising:

    - obtaining (S900, S1000) initial values of first and second frequencies ($f\_MW,av$, $f\_MW,d$) such that an estimate of a first resonance frequency and an estimate of a second resonance frequency of said nitrogen-vacancy centers are respectively substantially equal to the sum and the difference of the first and second frequencies;
    - generating (S901, S1001) a first microwave signal at the first frequency ($f\_MW,av$, $f'\_MW,av$) and a second microwave signal at the second frequency ($f\_MW,d$, $f'\_MW,d$), one of said first and second frequencies having been modulated at a third frequency ($f\_mod$);
    - processing (S902, S1002) the first and second microwave signals to obtain a third microwave signal comprising frequencies corresponding to the sum and the difference of the first and second frequencies;
    - obtaining (S903, S1003) said signal representative of said fluorescence produced by said nitrogen-vacancy centers exposed to a microwave field function of said third signal and an excitation light;
    - demodulating (S904, S1004) said signal representative of the fluorescence at said modulation frequency ($f\_mod$);
    - determining (S906, S 1006) a value of said physical parameter as a function of said demodulated signal.

13. Method according to claim 12, further comprising, in the case where the second signal is modulated, correcting (S905) said second frequency using a feedback loop in which an error signal is function of said demodulated signal.

14. Method according to claim 12, further comprising, in the case where the first signal is modulated, correcting (S1005) said first frequency using a feedback loop in which an error signal is function of said demodulated signal.

**FIG. 1**

**FIG. 2**

FIG. 3a

FIG. 3b

**FIG. 4**

**FIG. 5**

**FIG. 6**

EP 4 224 187 A1

**FIG. 7**

| External sensor | → | Adjustment (on f_MV,av) | → | Microwave generator 1 (f_MV,av) |

801                    802                    61, 73

# FIG. 8

S900
Obtain estimates of resonance frequencies (fest_NV,±1)
Obtain initial values for first and second frequencies
(f_MW,av and f_MW,d) such that the resonance frequency
estimates are equal to the sum and the difference of the
first and second frequencies

S901
Generate a first microwave signal at the first frequency
Generate a second microwave signal at the second
frequency, with a frequency modulation at $f_{mod}$

S902
Combine the first and second microwave signals to obtain a
third microwave signal comprising frequencies
corresponding to the sum and the difference of the first and
second frequencies

S905
Feedback loop to
correct second
frequency

S903
Apply the third microwave signal to
the NV doped diamond to excite NV
centers
Obtain fluorescence signal

S904
Demodulate fluorescence signal at
$f_{mod}$

S906
Obtain measurement value

# FIG. 9

S1000
Obtain estimates of resonance frequencies (fest_NV,±1)
Determine initial values for first and second frequencies
(f_MW,av and f_MW,d) such that the resonance frequency
estimates are equal to the sum and the difference of the
first and second frequencies

S1001
Generate a first microwave signal at the first frequencywith
a frequency modulation at $f_{mod}$
Generate a second microwave signal at the second
frequency

S1002
Combine the first and second microwave signals to obtain a
third microwave signal comprising frequencies
corresponding to the sum and the difference of the first and
second frequencies

S1005
Feedback loop to
correct first
frequency

S1003
Apply the third microwave signal to
the NV doped diamond to excite NV
centers
Obtain fluorescence signal

S1004
Demodulate fluorescence signal at
$f_{mod}$

S1006
Obtain measurement value

# FIG. 10

Europäisches
Patentamt

European
Patent Office

Office européen
des brevets

# EUROPEAN SEARCH REPORT

Application Number

EP 22 30 5123

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FESCENKO ILJA ET AL: "Diamond magnetometer enhanced by ferrite flux concentrators", PHYSICAL REVIEW RESEARCH, vol. 2, no. 2, 24 June 2020 (2020-06-24), XP055936990, DOI: 10.1103/PhysRevResearch.2.023394 * the whole document * | 1-14 | INV. G01R33/26 G01R33/32 G01N24/00 |
| A | US 2019/178959 A1 (BARRY JOHN FRANCIS [US] ET AL) 13 June 2019 (2019-06-13) * paragraph [0032] - paragraph [0040] * | 1,12 | |
| A | JENNIFER M SCHLOSS ET AL: "Simultaneous Broadband Vector Magnetometry Using Solid-State Spins", ARXIV.ORG, CORNELL UNIVERSITY LIBRARY, 201 OLIN LIBRARY CORNELL UNIVERSITY ITHACA, NY 14853, 10 March 2018 (2018-03-10), XP081408976, DOI: 10.1103/PHYSREVAPPLIED.10.034044 * chapterr 2; figure 2 * | 1,12 | |
| A | ADAM M WOJCIECHOWSKI ET AL: "Precision temperature sensing in the presence of magnetic field noise and vice-versa using nitrogen-vacancy centers in diamond", ARXIV.ORG, CORNELL UNIVERSITY LIBRARY, 201 OLIN LIBRARY CORNELL UNIVERSITY ITHACA, NY 14853, 20 February 2018 (2018-02-20), XP081217012, DOI: 10.1063/1.5026678 * the whole document * | 1,12 | |

TECHNICAL FIELDS
SEARCHED (IPC)

G01R
G01N

The present search report has been drawn up for all claims

| Place of search | Date of completion of the search | Examiner |
|---|---|---|
| Munich | 30 June 2022 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 30 5123

This annex lists the patent family members relating to the patent documents cited in the above-mentioned European search report.
The members are as contained in the European Patent Office EDP file on
The European Patent Office is in no way liable for these particulars which are merely given for the purpose of information.

30-06-2022

| Patent document cited in search report | | Publication date | Patent family member(s) | | Publication date |
|---|---|---|---|---|---|
| US 2019178959 | A1 | 13-06-2019 | US | 2019178959 A1 | 13-06-2019 |
| | | | WO | 2017213928 A1 | 14-12-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- High Sensitivity Magnetometers. Springer International Publishing, 2017, 553-576